# EUROPEAN PATENT APPLICATION

(11) **EP 3 823 034 A1**
(43) Date of publication of application: **19.05.2021**
(21) Application number: 19208699.9
(22) Date of filing: 12.11.2019
(51) Int. Cl.: H01L 29/06, H01L 21/02, H01L 23/00, H01L 29/40, H01L 29/78, H01L 23/31

(54) **HIGH VOLTAGE SEMICONDUCTOR DEVICE WITH STEP TOPOGRAPHY PASSIVATION LAYER STACK**

(71) Applicant: Infineon Technologies AG, 85579 Neubiberg (DE)
(72) Inventor: KOPROWSKI, Angelika, 9020 Klagenfurt (AT); KAHN, Markus, 9833 Rangersdorf (AT); HUMBEL, Oliver, 9182 Maria Elend (AT); SCHAEFFER, Carsten, 9520 Annenheim (AT)
(74) Representative: Lambsdorff & Lange Patentanwälte Partnerschaft mbB

(57) **Abstract**

A high voltage semiconductor device includes a high voltage electrically conductive structure and a step topography at or in the vicinity of the high voltage electrically conductive structure. A layer stack covers the step topography. The layer stack includes an electrically insulating buffer layer, a SiC layer over the electrically insulating buffer layer and a silicon nitride layer over the SiC layer or a nitrided surface region of the SiC layer.

## Description

### Technical Field

This disclosure relates generally to the field of high voltage semiconductor devices, and in particular to a passivation structure of high voltage semiconductor devices.

### Background

High voltage semiconductor devices need to take precautionary measures to rule out access of moisture into the active region of the device. The conventional approach is to provide for a thick passivation layer (e.g. a silicon nitride layer) to cover and protect the underlying structures, e.g. metal layers or other semiconductor or oxide device structures. Metal layers, when corroded by moisture, expand in volume and may crack the passivation layer resulting in a device failure. Humidity-driven ion transport into the gate oxide or into the bulk semiconductor material may change the on/off hysteresis characteristics of the device in an unwanted manner. Therefore, an extremely high degree of impermeability and stability of the passivation layer is required. In particular this is challenging at step topographies, because vulnerability of the passivation layer is more likely to occur at the edges of such step topographies.

### Summary

According to an aspect of the disclosure, a high voltage semiconductor device includes a high voltage electrically conductive structure and a step topography at or in the vicinity of the high voltage electrically conductive structure. A layer stack covers the step topography. The layer stack includes an electrically insulating buffer layer, a SiC layer over the electrically insulating buffer layer and a silicon nitride layer over the SiC layer or a nitrided surface region of the SiC layer.

### Brief description of the drawings

The elements of the drawings are not necessarily to scale relative to each other. Like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1A is a schematic cross-sectional illustration of an exemplary step topography of a high voltage semiconductor device covered by a layer stack including a silicon nitride layer over a SiC layer.
Figure 1B is a schematic cross-sectional illustration of an exemplary step topography of a high voltage semiconductor device covered by a layer stack including a SiC layer having a nitrided surface region.
Figure 2 is a schematic cross-sectional illustration of an exemplary high voltage semiconductor device showing a part of the active cell structure and the edge termination of the device, and including a layer stack for passivation over a surface topography.
Figure 3 is a schematic cross-sectional illustration of an exemplary high voltage semiconductor device including a layer stack for passivation over a surface topography.
Figure 4A is a schematic cross-sectional partial view of an exemplary layer stack for passivation.
Figure 4B is a schematic cross-sectional partial view of an exemplary layer stack for passivation.
Figures 5A to 5D are schematic illustrations of the degree of edge and sidewall coverage of a step topography for different intermediate layers used for the layer stack.
Figure 6 is a partial sectional view of an exemplary high voltage semiconductor device showing a transitional area between an active cell region and an edge termination of the exemplary high voltage semiconductor device.
Figure 7 is a contour-traced electron microscope image of an exemplary layer stack over a step topography for passivation.

### Detailed description

It is to be understood that the features of the various exemplary embodiments and examples described herein may be combined with each other, unless specifically noted otherwise.

As used in this specification, the terms "deposited", "covered by", "connected" and/or "electrically connected" are not meant to mean that the elements or layers must directly be contacted together; intervening elements or layers may be provided between the "deposited", "covered by", "connected", and/or "electrically connected" elements, respectively. However, in accordance with the disclosure, the above-mentioned terms may, optionally, also have the specific meaning that the elements or layers are directly contacted together, i.e. that no intervening elements or layers are provided between the "deposited", "covered by", "connected", and/or "electrically connected" elements, respectively.

Further, the word "over" used with regard to a part, element or material layer formed or located or arranged "over" a surface may be used herein to mean that the part, element or material layer be located (e.g. placed, formed, arranged, deposited, etc.) "directly on", e.g. in direct contact with, the implied surface. The word "over" used with regard to a part, element or material layer formed or located or arranged "over" a surface may either be used herein to mean that the part, element or material layer be located (e.g. placed, formed, arranged, deposited, etc.) "indirectly on" the implied surface with one or more additional parts, elements or layers being arranged between the implied surface and the part, element or material layer.

In particular, high voltage semiconductor devices may involve semiconductor chips having a vertical or horizontal structure. That is to say that a semiconductor chip of a high voltage vertical semiconductor device (e.g. being the high voltage vertical semiconductor device) may be fabricated in such a way that electric currents are flowing in a direction perpendicular to the main faces of the semiconductor chip. A semiconductor chip having a vertical structure usually has load electrodes on its two main faces, that is to say on its top side and bottom side (the bottom side is also referred to as backside herein). On the contrary, in a horizontal semiconductor device, the electrical currents are flowing in a direction parallel to the main faces of the semiconductor chip and the load electrodes are usually placed on the front main face of the semiconductor chip.

The high voltage semiconductor device (e.g. a semiconductor chip) may, for example, be configured as an IGBT (Insulated Gate Bipolar Transistor), a FET (Field Effect Transistor), in particular a MOSFET (Metal Oxide Semiconductor FET), a JFET (Junction Gate FET), a thyristor, specifically a GTO (Gate Turn-Off) thyristor, a BJT (Bipolar Junction Transistor), an HEMT (High Electron Mobility Transistor), or a diode. By way of example, a source electrode and a gate electrode of, e.g., a FET or MOSFET may be situated on the front side main face, while the drain electrode of the FET or MOSFET may be arranged on the backside main face.

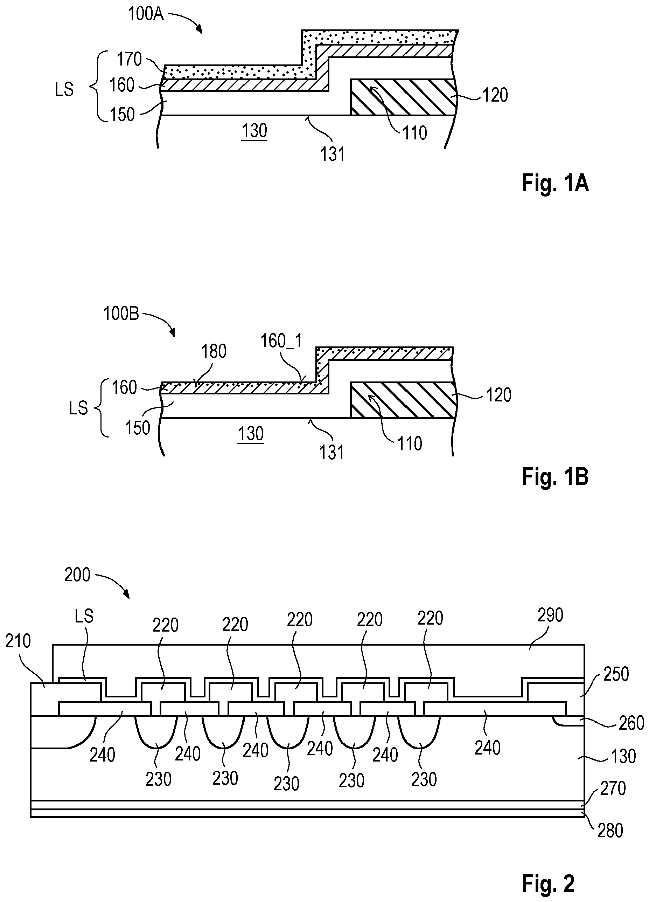

Referring to Figure 1A, a step topography 110 of a high voltage semiconductor device 100A is illustrated. In Figure 1A the step topography 110 is, e.g., formed by a high voltage electrically conductive structure 120, which is, e.g., made of metal. All kinds of metal or metal alloy may be used for the high voltage electrically conductive structure 120, though in many cases the metal may comprise or be of aluminum or copper or an alloy of aluminum or copper. Examples of the step topography 110 and the high voltage electrically conductive structure 120 are set out further below. It is to be noted that the step topography 110 does not need to be directly formed by the high voltage electrically conductive structure 120, however, it may be located relatively close to this structure 120 so as to be subjected to high electrical fields during operation of the high voltage semiconductor device 100A.

The step topography 110 and/or the high voltage electrically conductive structure 120 may be provided over a semiconductor substrate 130, e.g. on or over a surface 131 of the semiconductor substrate 130. The semiconductor substrate 130 may comprise or be of a semiconductor material such as, e.g., Si, SiC, SiGe, GaAs, GaN, AlGaN, InGaAs, InAlAs, etc. For instance, the semiconductor substrate 130 may be a wafer or a chip.

The electrically conductive structure 120 may be configured to be applied with a high voltage of equal to or greater than 0.6 kV, 1 kV, 2 kV, 3kV or 4 kV or 5 kV or 6 kV or 6.5 kV during operation. This voltage may be applied between a first electrode (e.g. electrically conductive structure 120 or another electrically conductive structure connected with the electrically conductive structure 120) and a second electrode of the high voltage semiconductor device 100A (e.g. a backside electrode (not shown) arranged, e.g., at a surface of the semiconductor substrate 130 opposite the surface 131 shown in Figure 1A).

A number of details may be omitted in the schematic illustration of Figure 1A. For instance, a barrier layer (not shown) may be provided between the surface 131 of the semiconductor substrate 130 and the electrically conductive structure 120. Further, the semiconductor substrate 130 may be structured (not shown) by including doped zones or trenches etc. Some of these possibilities will be described in greater detail further below.

The step topography 110 is covered by a layer stack LS comprising an insulating buffer layer 150, a SiC layer 160 arranged over the electrically insulating buffer layer 150 and a silicon nitride layer 170 arranged over the SiC layer 160.

In general, the SiC layer 160 may, e.g., be a crystalline or polycrystalline or amorphous SiC layer. Without loss of generality, the SiC layer will be exemplified in the following by an amorphous SiC layer containing hydrogen. Such amorphous SiC layer containing hydrogen is referred to as an a-SiC:H layer 160. The a-SiC:H layer 160 could anywhere in this disclosure be generalized to represent a SiC layer.

Figure 1B illustrates a partial view of a high voltage semiconductor device 100B showing another layer stack LS arranged over the step topography 110. The layer stack LS of high voltage semiconductor device 100B includes the insulating buffer layer 150 and the (exemplary) a-SiC:H layer 160. However, instead of the silicon nitride layer 170, the a-SiC:H layer 160 (generally, the SiC layer) includes a nitrided surface region 180 at a top surface 160_1 of the a-SiC:H layer 160. All other features and properties of the high voltage semiconductor device 100B may be similar or identical to the features or properties of the high voltage semiconductor device 100A, and reiteration of the same is avoided for sake of brevity.

Referring to Figure 2, an exemplary surface topography of a high voltage semiconductor device 200 is shown. The surface topography may contain multiple step topographies including, e.g., an active metal electrode 210 and/or metallic field plates 220 arranged over the semiconductor substrate 130. Doped field-rings (also referred to as p-rings) 230 may be provided in the substrate 130 and are electrically connected to the metallic field plates 220. An insulating layer 240 may be arranged over the semiconductor substrate 130 between the field rings 230 and the metallic field plates 220. A further step topography of the high voltage semiconductor device 200 may be formed by a peripheral conductive structure 250 arranged at the edge termination of the semiconductor substrate 130 (e.g. semiconductor chip). The peripheral conductive structure 250, which may be formed, e.g., of metal or of polysilicon, may be connected to a channel stopper 260 formed by, e.g., an n⁺⁺ doped region of the semiconductor substrate 130. The high voltage may, e.g., be applied between the active metal electrode 210 and/or the field plates 220 and the peripheral conductive structure 250.

The active metal electrode 210 may, e.g., form a load electrode (e.g. source or drain electrode) or a so-called gate runner of the high voltage semiconductor device 200.

The active metal electrode 210, the metallic field plates 220 and the peripheral conductive structure 250 may all be made of the same metal, e.g. aluminum or copper or an aluminum or copper alloy (e.g. the aluminum alloy AlSiCu having a Si percentage of about 1.0 wt% and a Cu percentage of about 0.5 wt%, the balance aluminum).

The portion of the high voltage semiconductor device 200 depicted in Figure 2, which includes e.g. the active metal electrode 210 and/or the metallic field plates 220 and/or the peripheral conductive structure 250 may represent a high voltage edge termination region of the high voltage semiconductor device 200 which surrounds an inner active zone of the high voltage semiconductor device 200 which is not (or only to the small extent of the active metal electrode 210) depicted in Figure 2. More specifically, the high voltage semiconductor device 200 may be formed by a high voltage semiconductor chip and the illustration of Figure 2 may depict a cross sectional view of the edge termination region of the high voltage semiconductor chip.

At the backside of the semiconductor substrate 130 a semiconductor contact zone 270 may be formed to provide electrical contact to a backside metallization layer 280. The semiconductor contact zone 270 may be formed by a substrate region which is doped higher (e.g. n doped) than the (e.g. n⁻ doped) semiconductor substrate 130.

At least one of the step topographies (which in the example of Figure 2 are formed by the active metal electrode 210, the metallic field plates 220 and the peripheral conductive structure 250) is covered by the layer stack LS. The layer stack LS may have a design as shown in Figure 1A or Figure 1B.

Further, an imide layer 290 may be arranged over the layer stack LS and may, e.g., completely cover the layer stack LS. The imide layer 290 may be a conformal layer (not shown) or a non-conformal layer, i.e. in the latter case it levels the step topographies over the semiconductor substrate 130.

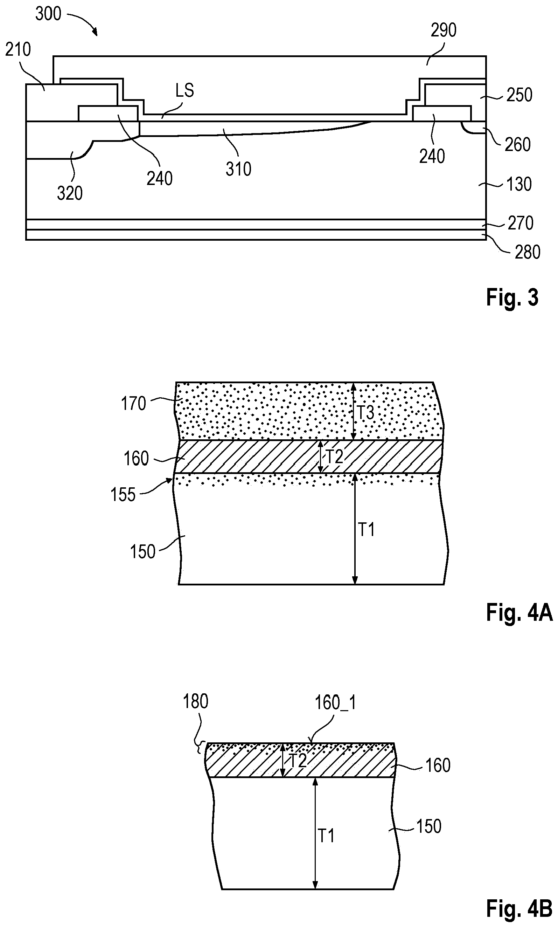

Figure 3 illustrates a further example of a high voltage semiconductor device 300 or, more specifically, an edge termination region thereof. Here, the semiconductor substrate 130 includes in its edge termination region or high voltage peripheral zone a so-called VLD (Variation of Lateral Doping) structure 310. The VLD structure 310 is doped more weakly than a laterally adjacent well 320, which is located at a boundary to the inner active zone of the high voltage semiconductor device 300. The VLD structure 310 has a doping concentration which decreases in the lateral direction towards the edge of the semiconductor substrate 130 (e.g. towards the channel stopper 260, which is located at the edge of the semiconductor substrate 130) .

As shown in Figure 3, the layer stack LS covers at least one of the step topographies shown in Figure 3, e.g. a step topography formed by the active metal electrode 210, a step topography formed by the insulating layer 240 in the vicinity of the active metal electrode 210, the step topography formed by the insulating layer 240 in the vicinity of the peripheral conductive structure 250 and/or the step topography formed by the peripheral conductive structure 250. Again, the layer stack LS may, e.g., have a design as shown in Figure 1A or Figure 1B, and reference is made to the above description of Figures 1A, 1B and 2 in order to avoid reiteration.

Figure 4A illustrates the layer stack LS of Figure 1A. A thickness T1 of the insulating buffer layer 150 (e.g. silicon oxide layer) may be equal to or greater than 100 nm and equal to or smaller than 5 µm. In particular, the thickness T1 may range between 1 µm and 3 µm.

The insulating buffer layer 150 may be formed by a plasma process using, e.g., N₂O and silane as process gases. Another possibility is to provide for a high purity oxide which can be produced in a plasma process using silane and O₂ as process gases. A sputter process (e.g. using Ar as a sputter gas) may be added for edge rounding.

Optionally, a surface region of the insulating buffer layer (e.g. insulating oxide layer) 150 may be nitrided. A nitridation of the surface region may be achieved by adding NH₃ and N₂ to the plasma process. A nitrided surface region of the insulating buffer layer 150 is indicated by reference sign 155. The nitrided surface region 155 of the insulating buffer layer 150 may have a depth of only a few nm.

The nitrided surface region 155 of an insulating oxide layer used as the insulating buffer layer 150 provides for an oxygen-depleted top surface of the insulating oxide layer 150. This greatly enhances the adhesive strength of the a-SiC:H layer 160 (or generally the SiC layer) on the underlying insulating oxide layer 150, since C of the a-SiC:H layer 160 is prevented from combining with O of the underlying insulating oxide layer 150.

The a-SiC:H layer 160 (or, more generally, the SiC layer) is a key layer of the layer stack LS in view of the improved functionality of the layer stack LS in terms of impermeability and stability of the layer stack LS against humidity and ion transfer. As will be demonstrated in more detail further below, the a-SiC:H layer 160 can be produced to completely cover vertical side walls and edge structures of a step topography with high conformity and without any growth gaps (also referred to as seamlines).

The a-SiC:H layer 160 may have a thickness T2 between 50 nm and 1 µm, more specifically between 100 nm and 0.5 µm. The maximum thickness of about 1 µm is due to mechanical strain introduced by the a-SiC:H layer 160.

The a-SiC:H layer 160 may be applied by a plasma process, e.g. by a plasma process carried out in the same plasma chamber as the plasma process to generate the insulating buffer layer 150. CH₄ and/or C₂H₂ may be used as process gases together with, e.g., silane. As the a-SiC:H layer 160 is not etched during the plasma deposition process, vertical sidewalls and edges of any step topography are perfectly and tightly passivated by the a-SiC:H layer 160. Therefore, any edge termination concept (as, e.g., exemplified in Figures 2 and 3) configured to have a step topography at or in the vicinity of high voltage electrically conductive structures can effectively be shielded against environmental impact by using the a-SiC:H layer 160 in the layer stack LS.

Further, the silicon nitride layer 170 may be deposited over the a-SiC:H layer 160. The silicon nitride layer 170 may have a thickness T3 ranging between 10 nm and 2 µm, in particular between 200 nm and 1 µm. The silicon nitride layer 170 may be applied by another plasma process performed, e.g., in the same plasma chamber as used for the two other layer stack LS deposition processes to generate the insulating oxide layer 150 and the a-SiC:H layer 160. The silicon nitride layer 170, on the one hand, provides for a good adhesion to a following layer, e.g. the imide layer 290 (see Figures 2, 3 or 6). Further, the silicon nitride layer 170 may act as an (additional) humidity barrier and hence as a protection layer for the a-SiC:H layer 160.

As shown in Figure 4B, it may also be possible that the silicon nitride layer 170 is omitted and replaced by a nitrided surface region 180 of the a-SiC:H layer 160. This nitrided surface region 180 (which is not a separate layer and thus does not add to the total layer thickness of the layer stack LS) may have a depth of only a few nm from the top surface 160_1 of the a-SiC:H layer 160. The nitrided surface region 180 of the a-SiC:H layer 160 likewise provides for a good adhesion to a following layer, e.g. the imide layer 290 (see Figures 2, 3 or 6).

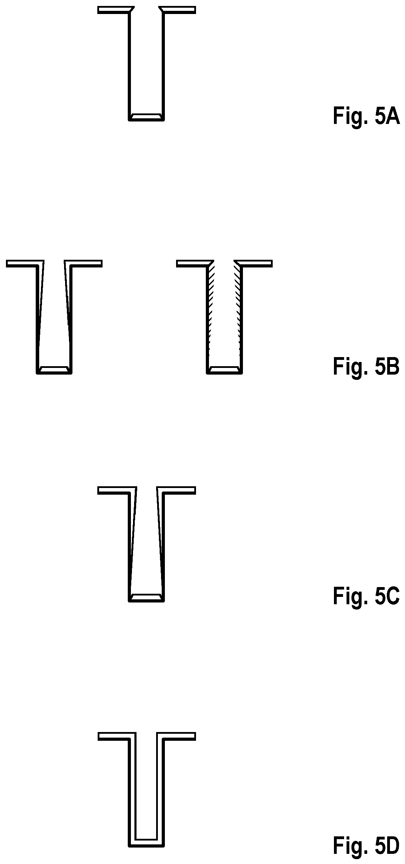

Figures 5A through 5D schematically illustrate the effect of different types of "intermediate" layers of the layer stack LS which had been tested in view of their ability to provide for an effective passivation of the layer stack LS.

If a hard a-C:H layer instead of the a-SiC:H layer 160 is generated (e.g. by using CH₄ as a plasma process gas), vertical sidewalls of a step topography are not covered, see Figure 5A. If C₂H₂ is used as a plasma process gas, a soft a-C:H layer can be generated, which only provides for about 50 % sidewall coverage (see left portion of Figure 5B), or a hard a-C:H layer can be generated, which was untight or with reduced barrier function at step topography structures (see right portion of Figure 5B). A hard SiN layer, as depicted in Figure 5C, also fails to provide sufficient degree of coverage and tightness at step topography structures. Only the a-SiC:H layer 160 was found to provide for high tightness and full sidewall and edge coverage of step topography structures while being applicable in a low temperature plasma process, see Figure 5D.

It is to be noted that the insulating buffer layer 150 (e.g. insulating oxide layer) allows to hold the a-SiC:H layer 160 electrically floating. This avoids any electrochemical interaction of the a-SiC:H layer 160. Further, the insulating buffer layer 150 (e.g. insulating oxide layer) facilitates process integration of the generation of the a-SiC:H layer 160, since anisotropic etching of the a-SiC:H layer 160 would be more difficult in the presence of exposed metal (because the anisotropic etching would sputter exposed metal).

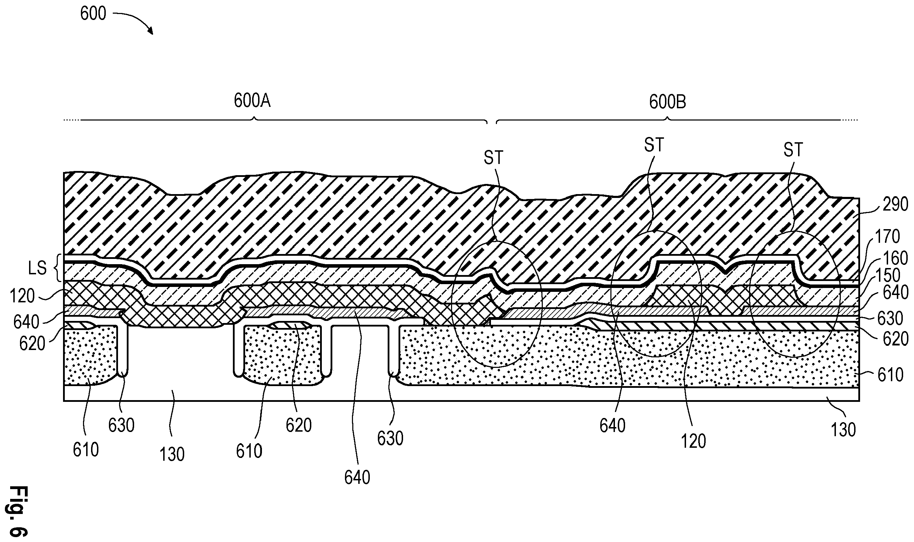

Figure 6 is a partial sectional view of an exemplary high voltage semiconductor device 600 showing a transitional area between an active cell region 600A and a transition region 600B to the edge termination region of the high voltage semiconductor device 600 (e.g. a semiconductor chip). In this example, 610 denotes a p-doped area of the semiconductor (e.g. silicon) substrate 130, 620 denotes a LOCOS (LOCal Oxidation of Silicon) oxide layer, 630 denotes a polysilicon layer, and 640 denotes an intermediate oxide layer. Encircled are step topography (ST) structures which are effectively protected by the conformal layer stack LS. In this example, the imide layer 290 is, e.g., a conformal layer.

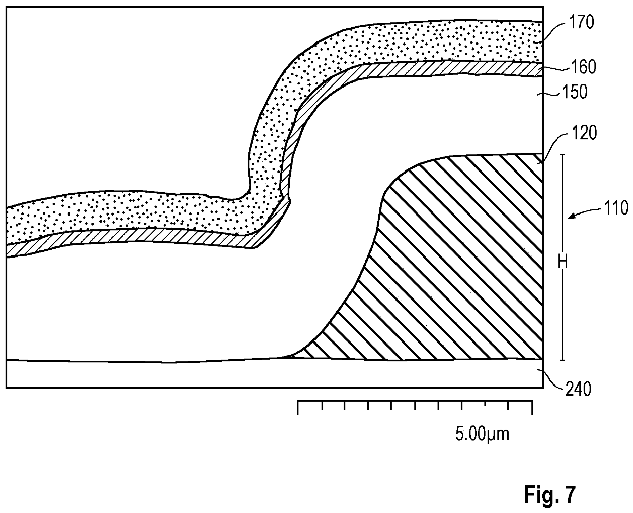

Figure 7 is a contour-traced electron microscope image of an exemplary layer stack LS over a surface step topography 110 for passivation. The step topography 110 comprises a horizontal base and a vertical sidewall.

Generally, the vertical sidewall may, e.g., have a height H equal to or greater than or less than 0.5 µm or 1 µm or 2 µm or 3 µm or 5 µm or 7 µm or 10 µm. In the exemplary layer stack LS of Figure 7 the height H is about 4 µm. As mentioned before, the step topography 110 may, e.g., be formed by an electrically conductive structure. Figure 7 is true to scale and hence discloses exemplary relative and/or absolute dimensions.

The exemplary layer stack LS of Figure 7 comprises or consists of an insulating oxide layer 150 of thickness T1 = 2700 nm, an a-SiC:H layer 160 of thickness T2 = 300 nm and a silicon nitride layer 170 of thickness T3 = 800 nm. The step topography 110 of Figure 7 is (exemplarily) formed by an electrically conductive structure 120 of a height of about 3.2 µm.

Figure 7 illustrates the high degree of conformity and integrity of the layer stack LS comprising the insulating oxide layer 150, the silicon nitride layer 170 and the intermediate a-SiC:H layer 160. In particular, a full coverage of the vertical sidewall of the step topography 110 and of the edge or corner region between the horizontal base and the vertical sidewall of the step topography 110 is obtained. No weak areas or zones of decreasing thickness or integrity of the layer stack LS, and in particular the a-SiC:H layer 160, are obtained.

The following examples pertain to further aspects of the disclosure:
Example 1 is a high voltage semiconductor device, comprising a high voltage electrically conductive structure; a step topography at or in the vicinity of the high voltage electrically conductive structure; and a layer stack covering the step topography, the layer stack comprising an electrically insulating buffer layer; a SiC layer over the electrically insulating buffer layer; and a silicon nitride layer over the SiC layer or a nitrided surface region of the SiC layer.
In Example 2, the subject matter of Example 1 can optionally include wherein the step topography is formed by an edge of the high voltage electrically conductive structure.
In Example 3, the subject matter of Example 1 or 2 can optionally include wherein the step topography is formed by a gate runner edge or a p-ring edge or a field plate edge or an edge of a varying lateral doping zone of a high voltage transistor.
In Example 4, the subject matter of any preceding Example can optionally include wherein the SiC layer is an a-SiC:H layer.
In Example 5, the subject matter of any preceding Example can optionally include wherein the electrically insulating buffer layer comprises a nitrided top surface region.
In Example 6, the subject matter of any preceding Example can optionally include wherein the electrically insulating buffer layer is an oxide layer.
In Example 7, the subject matter of any preceding Example can optionally include wherein the high voltage electrically conductive structure comprises aluminium or copper.
In Example 8, the subject matter of any preceding Example can optionally further include an imide layer over the silicon nitride layer or over the nitrided surface region of the SiC layer.
In Example 9, the subject matter of any preceding Example can optionally include wherein the step topography comprises a horizontal base and a vertical sidewall, and the vertical sidewall has a height equal to or greater than 0.5 µm or 1 µm or 2 µm or 3 µm or 5 µm or 7 µm or 10 µm.
In Example 10, the subject matter of any preceding Example can optionally include wherein the step topography comprises a horizontal base and a vertical sidewall, and the SiC layer completely covers the corner region between the horizontal base and the vertical sidewall.
In Example 11, the subject matter of Example 10 can optionally include wherein the SiC layer further completely covers the vertical sidewall.
In Example 12, the subject matter of any preceding Example can optionally include wherein the SiC layer is a conformal layer following the step topography.
In Example 13, the subject matter of any preceding Example can optionally include wherein the electrically insulating buffer layer is a conformal layer following the step topography.
In Example 14, the subject matter of any preceding Example can optionally include wherein the silicon nitride layer is a conformal layer following the step topography.
In Example 15, the subject matter of any preceding Example can optionally be configured such that the SiC layer is electrically floating.
In Example 16, the subject matter of any preceding Example can optionally be configured to operate at a voltage equal to or greater than 0.6 kV or 1 kV or 2 kV or 3 kV or 4 kV or 5 kV or 6 kV or 6.5 kV.
In Example 17, the subject matter of any preceding Example can optionally include wherein the high voltage semiconductor device is one of an IGBT, FET, diode, thyristor, GTO, JFET, MOSFET, BJT, and HEMT.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A high voltage semiconductor device, comprising:
a high voltage electrically conductive structure;
a step topography at or in the vicinity of the high voltage electrically conductive structure; and
a layer stack covering the step topography, the layer stack comprising:
an electrically insulating buffer layer;
a SiC layer over the electrically insulating buffer layer; and
a silicon nitride layer over the SiC layer or a nitrided surface region of the SiC layer.

2. The high voltage semiconductor device of claim 1, wherein the step topography is formed by an edge of the high voltage electrically conductive structure.

3. The high voltage semiconductor device of claim 1 or 2, wherein the step topography is formed by a gate runner edge or a p-ring edge or a field plate edge or an edge of a varying lateral doping zone of a high voltage transistor.

4. The high voltage semiconductor device of any of the preceding claims, wherein the SiC layer is an a-SiC:H layer.

5. The high voltage semiconductor device of any of the preceding claims, wherein the electrically insulating buffer layer comprises a nitrided top surface region.

6. The high voltage semiconductor device of any of the preceding claims, wherein the electrically insulating buffer layer is an oxide layer.

7. The high voltage semiconductor device of any of the preceding claims, wherein the high voltage electrically conductive structure comprises aluminium or copper.

8. The high voltage semiconductor device of any of the preceding claims, further comprising:
an imide layer over the silicon nitride layer or over the nitrided surface region of the SiC layer.

9. The high voltage semiconductor device of any of the preceding claims, wherein
the step topography comprises a horizontal base and a vertical sidewall, and
the vertical sidewall has a height equal to or greater than 0.5 µm or 1 µm or 2 µm or 3 µm or 5 µm or 7 µm or 10 µm.

10. The high voltage semiconductor device of any of the preceding claims, wherein
the step topography comprises a horizontal base and a vertical sidewall, and
the SiC layer completely covers the corner region between the horizontal base and the vertical sidewall.

11. The high voltage semiconductor device of claim 10, wherein the SiC layer further completely covers the vertical sidewall.

12. The high voltage semiconductor device of any of the preceding claims, wherein the SiC layer is a conformal layer following the step topography.

13. The high voltage semiconductor device of any of the preceding claims, wherein the electrically insulating buffer layer is a conformal layer following the step topography.

14. The high voltage semiconductor device of any of the preceding claims, wherein the silicon nitride layer is a conformal layer following the step topography.

15. The high voltage semiconductor device of any of the preceding claims, configured such that the SiC layer is electrically floating.

16. The high voltage semiconductor device of any of the preceding claims, configured to operate at a voltage equal to or greater than 0.6 kV or 1 kV or 2 kV or 3 kV or 4 kV or 5 kV or 6 kV or 6.5 kV.

17. The high voltage semiconductor device of any of the preceding claims, wherein the high voltage semiconductor device is one of an IGBT, FET, diode, thyristor, GTO, JFET, MOSFET, BJT, and HEMT.
